# EUROPÄISCHE PATENTSCHRIFT

(11) **EP 0 958 326 B1**
(45) Veröffentlichungstag und Bekanntmachung des Hinweises auf die Patenterteilung: **19.11.2003**
(21) Anmeldenummer: 98909334.9
(22) Anmeldetag: 05.02.1998
(51) Int. Cl.: C09J 5/06, C09J 163/00, C08G 59/68, H05K 3/38

(54) **VERFAHREN ZUM VERKLEBEN EINES BAUELEMENTS MIT EINER OBERFLÄCHE**
METHOD FOR GLUING A SURFACE TO A COMPONENT
PROCEDE POUR ASSEMBLER PAR COLLAGE UN COMPOSANT ET UNE SURFACE

(30) Priorität: 10.02.1997 DE 19705027
(43) Veröffentlichungstag der Anmeldung: 24.11.1999
(73) Patentinhaber: Infineon Technologies AG, 81669 München (DE)
(72) Erfinder: BAYER, Heiner, D-82140 Olching (DE); WIPFELDER, Ernst, D-81673 München (DE)
(74) Vertreter: Müller, Wolfram Hubertus, Dr. Dipl.-Phys.
(86) Internationale Anmeldenummer: DE9800317
(87) Internationale Veröffentlichungsnummer: WO98034992

(56) Entgegenhaltungen:
- EP-A- 0 604 090
- US-A- 5 242 715
- DATABASE WPI Section Ch, Week 9114 Derwent Publications Ltd., London, GB; Class A14, AN 91-096914 XP002066800 & JP 03 039 378 A (HITACHI CHEM CO LTD)
- PATENT ABSTRACTS OF JAPAN vol. 016, no. 289 (C-0956), 26.Juni 1992 & JP 04 076081 A (AISIN CHEM CO LTD;OTHERS: 01), 10.März 1992,

## Beschreibung

In vielen Bereichen der Technik werden Werkstücke bereits ausschließlich durch Verkleben verbunden und befestigt. Verdrängt werden dadurch herkömmliche Befestigungsverfahren wie Schweißen, Löten, Schrauben oder dergleichen. Für die stetig wachsenden Einsatzbereiche sind dabei Klebstoffe erforderlich, die den unterschiedlichsten Anforderungen genügen müssen. In der Elektronik und der optischen Nachrichtentechnik werden verstärkt Reaktionsharze zur zuverlässigen und kostengünstigen Montage verschiedener Materialien und Bauteile eingesetzt. Aus fertigungstechnischen Gründen werden dabei Einkomponentensysteme angestrebt, die ohne weitere Vorbehandlung direkt zum Verkleben eingesetzt werden können. Nachteilig daran ist, daß die Einkomponentensysteme erst bei erhöhter Temperatur rasch härtbar sind. Kurze Taktzeiten, wie sie für eine automatische Fertigung erforderlich sind, sind daher schwer zu realisieren.

Für verschiedene Klebeprobleme, insbesondere bei der optischen Nachrichtentechnik, ist eine exakte Justierung der zu verklebenden Bauteile erforderlich. Diese muß vor der endgültigen Härtung erfolgen, wobei die justierten Bauteile bis zur Härtung häufig noch fixiert werden müssen, da der Klebstoff während der Härtung einen niederviskosen Zustand durchläuft. Außerdem kann der Klebstoff ein Schwundverhalten aufweisen, welches wiederum eine Dejustierung zur Folge hat.

Neben der Dejustierung kann auch die thermische Belastung während der Härtung von einkomponentigen Reaktionsharzen zu starken Spannungen oder gar zu Schädigungen der zu verklebenden Teile bzw. Bauelemente führen. Die Temperaturempfindlichkeit von zu verklebenden Teilen kann die Härtungstemperatur außerdem nach oben begrenzen, so daß bei niedriger Temperatur härtende Klebstoffe erforderlich sind.

Eine Möglichkeit der schnellen Fixierung bieten UV-härtbare Klebestoffe. Diese weisen jedoch in vielen Fällen nicht die erforderliche Kombination an Eigenschaften auf, die zu einer dauerhaften und zuverlässigen Verklebung führen. In vielen Fällen wird daher ein zweiter Klebstoff, in der Regel ein Epoxidharz, eingesetzt, um die Zuverlässigkeit und Dauerhaftigkeit der Klebeverbindung sicherzustellen. Nachteilig daran ist, daß sich lichthärtendes Harz und Epoxidharz in unvorteilhafter Weise beeinflussen können. Auch schon die Notwendigkeit von zwei verschiedenen Klebstoffen ist an sich unerwünscht.

Aus der DE-A 40 38 989 ist ein Klebeverfahren mit Hilfe eines kationisch initiiert härtbaren Epoxidharzes bekannt, bei dem der Klebstoff mittels UV-Licht aktiviert wird und dann bei relativ milder Temperatur thermisch aushärtbar ist. Nachteilig an diesem Verfahren ist, daß für die rasche Fixierung eine Erwärmung der Klebestelle erfolgen muß, und die Übertragung einer ausreichenden Wärmemenge erforderlich ist. Dies begrenzt die Taktzeiten in automatischen Fertigungsverfahren. Außerdem härtet dieser Klebstoff nur dort, wo eine Bestrahlung erfolgt ist nicht an den Stellen, wo überhaupt keine Bestrahlung erfolgt ist.

Ein weiteres Problem besteht darin, einen für thermoplastische Oberflächen geeigneten Klebstoff zu finden, der eine schnelle und exakte Härtung ermöglicht.

Aufgabe der vorliegenden Erfindung ist es daher, ein Verfahren zur schnellen und exakten Verklebung von zwei Fügeteilen anzugeben, von denen zumindest eines eine thermoplastische Oberfläche aufweisen kann.

Diese Aufgabe wird erfindungsgemäß durch ein Verfahren nach Anspruch 1 gelöst. Vorteilhafte Ausgestaltungen der Erfindung gehen aus den Unteransprüchen hervor.

Das erfindungsgemäße Verfahren besteht aus den Verfahrensschritten
- Füllen einer Klebefuge zwischen dem Bauelement und einer Oberfläche zur Herstellung einer Klebestelle mit einem Klebstoff
- gegebenenfalls exaktes Justieren des Bauelements auf der Oberfläche
- Bestrahlen des Klebstoffs mit elektromagnetischer Strahlung im UV/VIS Bereich und dadurch Fixierung der Klebestelle
- anschließende thermische Härtung der Klebestelle.

Dabei wird im erfindungsgemäßen Verfahren ein Klebstoff auf Epoxidbasis verwendet, der folgende Bestandteile umfaßt:
- 20 bis 70 Gewichtsprozent eines kationischen härtbaren lösungsmittelfreien Epoxids, das das Umsetzungsprodukt eines cycloaliphatischen Diepoxids und einer aromatischen Verbindung, die phenolische OH-Gruppen aufweist, enthält.
- 10 bis 60 Gewichtsprozent einer mehrere Hydroxylgruppen enthaltenden Verbindung
- 0,02 bis 2 Gewichtsprozent eines kationischen Photoinitiators
- 0,02 bis 2 Gewichtsprozent eines latenten thermischen Initiators für die kationischen Polymerisation auf der Basis eines Thiolaniumsalzes
- 20 bis 60 Volumenprozent eine mineralischen Füllstoffes mit einer maximalen Teilchengröße von 50 µm

Es werden mit dem erfindungsgemäßen Verfahren Bauteile verklebt, von deren Oberflächen zumindest eine im Bereich der Klebestelle ein thermoplastisches Material umfaßt.

Dabei wird, wie oben beschrieben, ein Klebstoff auf Epoxidbasis verwendet, der mit Polyol modifiziert ist und Initiatoren sowohl für die lichtinduzierte kationische Härtung als auch für die thermische Härtung enthält. Überraschend hat sich nun gezeigt, daß mit einem solchen Klebstoff eine rasche und ausreichend sichere Fixierung der Klebestelle durch UV-Bestrahlung zum Beispiel mit einer UV-Lampe möglich ist. Die Fixierung erfolgt innerhalb von maximal 15 Sekunden und wird in einem Ausführungsbeispiel bereits bei 5 Sekunden Bestrahlungsdauer erreicht. Noch wesentlich kürzere Bestrahlungszeiten sind mit einem UV-Laser erreichbar. Durch den kationischen Katalysator ist es ausreichend, eine anteilsmäßig nur geringe Oberfläche des Klebstoffs bzw. der Klebestelle zu bestrahlen, um trotzdem eine ausreichende Fixierung der gesamten Klebeverbindung zu erzielen.

Die vollständige Härtung kann in einem späteren Temperaturschritt bei relativ mäßigen Temperaturen von beispielsweise 130 bis 150°C erfolgen. Dabei ist es möglich, mehrere Klebestellen gleichzeitig oder auch hintereinander'zunächst zu fixieren und die Klebestellen dann gemeinsam thermisch auszuhärten. Mehrere Klebestellen können sich dabei auf einem gemeinsamen Substrat befinden.

Überraschend hat sich auch gezeigt, daß mit dem erfindungsgemäßen Verfahren ausreichend feste Klebeverbindungen zwischen Bauteilen hergestellt werden können, von denen zumindest eines eine thermoplastische Oberfläche aufweist. Für solche Klebeprobleme waren bislang keine befriedigenden Lösungen auf der Basis von UV-härtbaren Epoxidharzen bekannt.

Besonders gute Klebeverbindungen werden zwischen thermoplastischen Oberflächen und metallischen oder metallisierten Oberflächen erhalten. Als Beispiel können vergoldete Teile von elektronischen Bauelementen dienen, die mit präzisen Spritzgussteilen aus Thermoplasten verbunden werden sollen.

Für eine besondere schwundarme Klebestelle mit geringem thermischen Ausdehnungskoeffizienten wird ein Klebstoff verwendet, der eine anorganischen oder mineralischen Füllstoff in einem Anteil von 20 bis 60 Volumenprozent enthält.

Bevorzugt sind Füllstoffe auf Kieselsäurebasis, beispielsweise Quarzmehle oder Quarzgutmehle. Besonders bevorzugt sind Feinstmehle mit maximale Partikeldurchmessern von 10 bis 50 um, die eine Miniaturisierung von Klebestellen ermöglichen. Mit solchen Klebstoffen können sehr dünne Klebefugen mit einem Abstand der zu fügenden Oberflächen von wenigen Mikrometern realisiert werden.

Es können im Verfahren beliebige Epoxide eingesetzt werden, beispielsweise Glycidylether auf der Basis von Bisphenol A, Bisphenol F oder Novolaken. Aber auch Glycidylether von Mehrfachalkolhol wie Glycerin und Pentaerythrit sind geeignet. Auch lineare aliphatische Epoxide, beispielsweise epoxidiertes Polybutadien und epoxidiertes Sojabohnenöl sind geeignet. Besonders geeignet sind cycloaliphatische Epoxide, beispielsweise 3,4-Epoxicyclohexymethyl-3',4'-Epoxicyclohexancarboxylat. Letztere zeichnen sich insbesondere durch eine hohe Reaktivität sowie eine niedrige Viskosität aus. Ferner können auch Mischungen anderer kationischen härtbarer Epoxide zugesetzt werden.

Die hydroxylgruppenhaltige Verbindung ist vorzugsweise ein mehrwertiger, aliphatischer oder cycloaliphatischer Alkohol. So können beispielsweise Glykole oder andere aliphatische Diole, tri- oder tetrafunktionelle Alkohole wie Trimethylolpropan oder Ether von Glykolen mit Phenolen oder Bisphenolen eingesetzt werden. Weitere geeignete Verbindungen sind Polymer-Polyole, die bei der Herstellung von Polyurethanen Verwendung finden. Beispielsweise seien hier die unter der Bezeichnung Niax ® und Tone ® von Dow Chemical angebotenen Polyole genannt.

Möglich ist es auch, als hydroxylgruppenhaltige Verbindungen solche Verbindungen einzusetzen, die durch Reaktion von Epoxidverbindungen mit Alkoholen oder Phenolen erhalten werden. Gut geeignet ist beispielsweise das Additionsprodukt eines cycloaliphatischen Epoxids mit einem Polyphenol, vorzugsweise mit einem Bisphenol wie beispielsweise Bisphenol A oder Naphthalindiol. Solche Additionsprodukte können basenkatalysiert unter milden Bedingungen erhalten werden. Ein bevorzugtes Additionsprodukt ist das 2:1 Addukt, bei dem ein Äquivalent phenolischer Gruppen mit zwei Equivalenten Epoxidgruppen umgesetzt ist. Ausgehend von einem Diepoxid und einem Bisphenol ist das 2:1 Addukt ebenfalls ein Diepoxid. Wird das Molverhältnis im Bereich von 2:1 bis 20:1 und vorzugsweise von 3:1 bis 10:1 gewählt, so weist das Addukt, bzw. die, das Addukt enthaltende Reaktionsmischung praktisch keine freien phenolischen OH-Gruppen mehr auf. Die Reaktionsmischung ist aber dennoch hydroxylgruppenhaltig, da durch Addition eines Phenols an die Epoxidgruppe neben der Etherbindung eine β-ständige Hydroxygruppe entsteht.

Wird für die hydroxylgruppenhaltige Verbindung das genannte Reaktionsprodukt mit hohem Epoxidüberschuß eingesetzt, so kann das Reaktionsprodukt im Klebstoff sowohl anstelle des Epoxids als auch anstelle der hydroxylgruppenhaltigen Verbindung eingesetzt werden.

Zur Initiierung der kationischen Härtung ist ein kationischer Photoinitiator oder ein kationisches Photoinitiatorsystem enthalten. Dessen Anteil am gesamten Epoxidharz kann 0,1 bis 5 Gewichtsprozent umfassen. Diese Photoinitiatoren setzen bei UV-Bestrahlung reaktive Kationen, zum Beispiel Protonen frei, die den kationischen Härtungsprozeß des Epoxidharzes initiieren. Die Photoinitiatoren sind dabei von stabilen organischen Oniumsalzen abgeleitet, insbesondere mit Stickstoff, Phosphor, Sauerstoff, Schwefel, Selen oder Jod als Zentralatom des Kations. Als besonders vorteilhaft haben sich aromatische Sulfonium- und Jodoniumsalze mit komplexen Anionen erwiesen. Auch ein eine Lewissäure freisetzender und beispielsweise als pi-Donor-Übergangsmetallkomplex realisierter Photoinitiator ist möglich. Weiterhin zu nennen sind Phenacylsulfoniumsalze, Hydroxyphenylsulfoniumsalze sowie Sulfoxoniumsalze. Einsetzbar sind weiterhin Oniumsalze, die nicht direkt, sondern über einen Sensibilisator zur Säurebildung angeregt werden. Auch organische Siliziumverbindungen, die bei UV-Bestrahlung in Anwesenheit von Aluminium-organischen Verbindungen ein Silanol freisetzen, können als Photoinitiatoren für den kationischen Härtungsprozeß eingesetzt werden.

Gut geeignet als Photoinitiator ist beispielsweise folgendes Sulfoniumsalz. Es ist ein Hauptbestandteil von Cyracure ® UVI 6974 (Union Carbide):

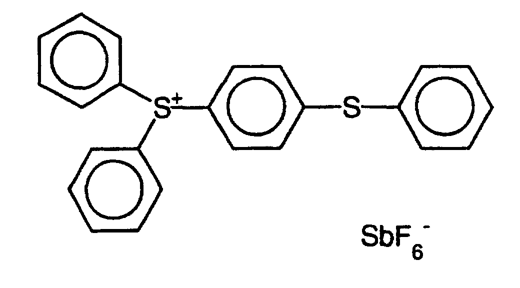

Als latenter thermischer Initiator für die kationische Polymerisation ist ein Thiolaniumsalz enthalten, vorzugsweise von der allgemeinen Struktur: 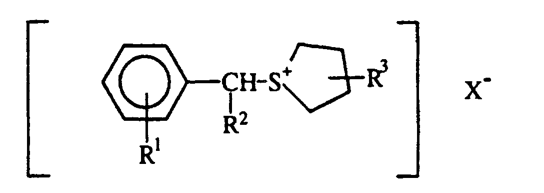 wobei R1 gleich Wasserstoff, Alkyl, Aryl, Alkoxy, Thioether, Halogen, CN oder NO₂; R2 gleich Wasserstoff, Alkyl oder Aryl; R3 gleich Wasserstoff, Alkyl oder Aryl oder ein an den Thiolanring kondensiertes aromatisches System; X⁻ = PF₆⁻; AsF₆⁻ oder Sb F₆⁻.

Bevorzugt werden dabei unsubstituierte Benzylthiolaniumsalze eingesetzt, insbesondere das Benzylthiolaniumhexafluoroantimonat.

Als Füllstoffe sind insbesondere mineralische Feinstmehle auf Kieselsäurebasis, beispielsweise Quarzmehle oder Quarzgutmehle geeignet.

Mit der Verwendung des genannten Klebstoffs läßt sich im erfindungsgemäßen Verfahren eine schnelle Fixierung der zu verklebenden Teile erzielen. Dafür kann eine Zeitspanne von weniger als einer Sekunde ausreichend sein. Andererseits ist der Klebstoff bei Raum- oder Verarbeitungstemperatur ausreichend stabil, so daß bei Raumtemperatur eine Lagerzeit von bis zu einem Jahr und bei einer Verarbeitungstemperatur von beispielsweise 40°C eine Verarbeitungszeit von ca. einer Woche gegeben ist. Damit ist auch in automatisierten Prozessen eine gute Verarbeitbarkeit gewährleistet, die keine zu häufige Reinigung der Verarbeitungsapparaturen und insbesondere der Klebstoffauftragsvorrichtung erforderlich macht.

Im folgenden wird die Erfindung anhand von Ausführungsbeispielen näher erläutert.

Für das Ausführungsbeispiel werden drei Klebstoffmischungen V1 bis V3 gemäß der folgenden Tabelle zusammengemischt. Die Mengen sind in Gewichtsteilen angegeben.

| | V1 | V2 | V3 |
|---|---|---|---|
| cycloaliphatisches Epoxid (CY179, Ciba) | 66 | 90 | 33 |
| Additionsprodukt von Bisphenol A an cycloaliphatisches Epoxid (OH 117, Siemens) | 13 | 30 | 6 |
| epoxidiertes Sojaöl (Edenol D20, Henkel) | 12 | 25 | 5 |
| Trimethylolpropan (Merck) | 8 | 2 | |
| Cyclohexandimethanol (Merck) | | 8 | |
| Pentandiol (Merck) TCD-Alkohol, (Hoechst) | | 7 | 2 |
| kationischer Photoinitiator, (UVI 6974, UCC) | 1,4 | 1,1 | 0,7 |
| kationischer thermischer Initiator (Benzylthiolaniumhexafluoroantimonat Aldrich) | 1 | 2 | 0,5 |
| Haftvermittler (A 187, UCC) | 0,4 | 0,5 | 0,3 |
| Verlaufshilfsmittel (Modaflow, Brenntag) | 0,2 | 0,3 | 0,1 |
| Quarzgutmehl (FB-3SX, Denka) Quarzgutmehl (FW 600, Denka) | 190 | 150 | 90 |
| Quarzgutmehl (VP 810) | | 10 | |
| Füllgrad | 65 % | 50 % | 65 % |

Zum Testen der Scherfestigkeit werden Probekörper aus unterschiedlichen Materialien miteinander verklebt. Dazu wird eine der zu verklebenden Oberflächen mit einer dünnen Klebstoffschicht von 50 bis 100 µm Dicke bestrichen, das zu verklebende Teil aufgesetzt, die Klebestelle von der Seite mit UV-Licht bestrahlt (5 Sekunden mit 50 mW/cm²) und die Klebestelle schließlich bei 150° für 30 Minuten vollständig ausgehärtet.

Auf einem Mikrotester werden Scherfestigkeitsprüfungen durchgeführt. Dabei zeigt sich, daß Metall Metallverklebungen eine ausgezeichnete Scherfestigkeit von bis zu 20 N/mm² ergeben. Auch thermoplastische Probekörper, die mit Metallsubstraten verklebt wurden, zeigten hohe Scherfestigkeiten von bis zu 10 N/mm². Mit Aluminium wurden beispielsweise folgende Thermoplaste verklebt und zeigten dabei eine ausreichende Haftung: LCP (Zenite 6330), PPS (Fortron 6165), PEEK (LFM 100-12). Bei den Abscherversuchen tritt erst bei hohen Scherkräften ein Kohäsionsbruch auf, meist bricht die Grenzfläche zum Thermoplasten oder dieser selbst in einer oberflächennahen Schicht.

Die Glasumwandlungstemperatur der angegebenen Klebstoffe liegt im Bereich von 130 bis 150°C (DSC).

Das erfindungsgemäße Verfahren und der dazu vorgeschlagene Klebstoff ist insbesondere zur automatisierten Verklebung von Bauelementen der Elektronik und der Optoelektronik geeignet, bei denen eine hohe Präzision gefordert ist. Die ausreichend lange Topfzeit bei gleichzeitig äußerst schneller Fixierbarkeit mit UV-Licht ermöglicht kurze Taktzeiten und damit einen hohen Maschinendurchsatz. Die vollständige Aushärtbarkeit gelingt relativ schnell und bei milden Temperaturen von ca. 130 bis 150°. Auf diese Weise können auch thermisch empfindliche Bauteile verklebt werden. Besonderer Vorteil des erfindungsgemäßen Verfahrens ist die Verklebbarkeit von thermoplastischen Teilen auf insbesondere metallischen oder anders gearteten Oberflächen. Die Klebstoffe zeigen einen geringen Schwund und ermöglichen exakt justierte Verklebungen mit sehr kleinen Toleranzen. Die Verklebung kann mit dünnen Klebefugen von zum Beispiel nur 80 ± 20 µm realisiert werden.

## Patentansprüche

1. Verfahren zum Verkleben eines Bauelements mit einer Oberfläche,
- bei dem eine Klebefuge zwischen dem Bauelement und einer Oberfläche zur Herstellung einer Klebestelle mit einem Klebstoff gefüllt wird
- bei dem das Bauelement auf der Oberfläche gegebenenfalls exakt justiert wird
- bei dem der Klebstoff mit elektromagnetischer Strahlung im UV/VIS Bereich bestrahlt wird und somit die Klebestelle fixiert wird
- bei dem die Klebestelle anschließend thermisch gehärtet wird,
- bei dem ein Klebstoff auf Epoxidbasis verwendet wird, der folgende Bestandteile umfaßt:
- 20 bis 70 Gewichtsprozent eines kationisch härtbaren lösungsmittelfreien Epoxids, das das Umsetzungsprodukt eines cycloaliphatischen Diepoxids und einer aromatischen Verbindung, die phenolische OH-Gruppen aufweist, enthält
- 10 bis 60 Gewichtsprozent einer mehrere Hydroxylgruppen enthaltenden Verbindung
- 0,02 bis 2 Gewichtsprozent eines kationischen Photoinitiators
- 0,02 bis 2 Gewichtsprozent eines latenten thermischen Initiators für die kationische Polymerisation auf der Basis eines Thiolaniumsalzes
- 20 bis 60 Volumenprozent eines mineralischen Füllstoffs mit einer maximalen Teilchengröße von 50 µm,
- wobei Bauteile verklebt werden, von deren Oberflächen zumindest eine im Bereich der Klebestelle ein thermoplastisches Material umfaßt.

2. Verfahren nach Anspruch 1,
bei dem Bestrahlung des Klebstoffs für 0,1 bis 10 Sekunden erfolgt.

3. Verfahren nach einem der Ansprüche 1 oder 2,
bei dem Bauelemente verklebt werden, welche zur Klebefuge hin metallische oder metallisierte Oberflächen aufweisen.

4. Verfahren nach einem der Ansprüche 1 bis 3,
bei dem die Klebefuge in einer Dicke von 10 bis 200 µm eingestellt wird.

5. Verfahren nach einem der Ansprüche 1 bis 4,
bei dem ein Klebstoff verwendet wird, der einen anorganischen oder mineralischen Füllstoff in einem Anteil von 20 bis 60 Volumenprozent enthält.

6. Verfahren nach einem der Ansprüche 1 bis 5,
bei dem der Klebstoff auf eine der zur Klebefuge hinweisenden Oberflächen aufgebracht wird und
bei dem die zu verklebenden Teile annähernd paßgenau aneinandergefügt, gegebenenfalls exakt positioniert und ausgerichtet und dabei oder kurz danach fixiert werden.

7. Anwendung des Verfahrens nach einem der vorausgehenden Ansprüche zur paßgenauen maschinellen Verklebung von elektrischen, elektronischen und optischen Bauelementen innerhalb kurzer Taktzeiten.

## Claims

1. Method for bonding a component to a surface, comprising
- filling a bondline between the component and a surface with a cement to produce a bondsite
- where appropriate precisely aligning the component on the surface
- irradiating the cement with electromagnetic radiation in the UV/VIS region and thereby fixing the bondsite
- subsequently thermally hardening the bondsite
- using an epoxy-based cement comprising the following constituents:
- 20 to 70 per cent by weight of a cationically hardenable solvent-free epoxy comprising the reaction product of a cycloaliphatic diepoxide and an aromatic compound containing phenolic OH groups
- 10 to 60 per cent by weight of a compound containing plural hydroxyl groups
- 0.02 to 2 per cent by weight of a cationic photoinitiator
- 0.2 to 2 per cent by weight of a latent thermal initiator for the cationic polymerization, based on a thiolanium salt
- 20 to 60 per cent by volume of a mineral filler with a maximum particle size of 50 µm
- bonding components at least one of whose surfaces, in the region of the bondsite, comprises a thermoplastic material.

2. Method according to Claim 1, wherein the cement is irradiated for from 0.1 to 10 seconds.

3. Method according to either of Claims 1 and 2, wherein components are bonded which have metallic or metallized surfaces facing the'bondline.

4. Method according to one of Claims 1 to 3, wherein the bondline is established in a thickness of from 10 to 200 µm.

5. Method according to one of Claims 1 to 4, wherein a cement is used which comprises an inorganic or mineral filler in a fraction of from 20 to 60 per cent by volume.

6. Method according to one of Claims 1 to 5, wherein the cement is applied to one of the surfaces pointing toward the bondline and wherein the parts to be cemented are joined with an approximately accurate fit, positioned precisely where appropriate and aligned, and in the course thereof or shortly thereafter are fixed.

7. Application of the method according to one of the preceding claims to the mechanical bonding of electrical, electronic and optical components with accurate fit within short cycle times.

## Revendications

1. Procédé de collage d'un composant à une surface
- dans lequel on emplit d'une colle un joint de collage entre le composant et une surface pour produire un endroit de collage,
- dans lequel on ajuste éventuellement exactement le composant sur la surface,
- dans lequel on expose la colle à du rayonnement électromagnétique dans le domaine UV/visible et on fixe ainsi l'endroit de collage,
- dans lequel on durcit ensuite thermiquement l'endroit de collage,
- dans lequel on utilise une colle à base d'époxyde qui comprend les constituants suivants :
- de 20 à 70 % en poids d'un époxyde exempt de solvant pouvant durcir cationiquement et contenant le produit de réaction d'un diépoxyde cycloaliphatique et d'un composé aromatique qui a des groupes OH phénoliques,
- de 10 à 60 % en poids d'un composé contenant plusieurs groupes hydroxyles,
- de 0,02 à 2 % en poids d'un photoamorceur cationique,
- de 0,02 à 2 % en poids d'un amorceur thermique latent de polymérisation cationique à base d'un sel de thiolanium,
- de 20 à 60 % en volume d'une charge minérale ayant une granulométrie maximum de 50 µm,
- en collant des composants dont la surface comprend au moins une matière thermoplastique dans la zone de l'emplacement de collage.

2. Procédé suivant la revendication 1, dans lequel on expose la colle à un rayonnement pendant 0,1 à 10 secondes.

3. Procédé suivant l'une des revendications 1 ou 2, dans lequel on colle des composants qui ont vers le joint de colle des surfaces métalliques ou métallisées.

4. Procédé suivant l'une des revendications 1 à 3, dans lequel on règle le joint de colle à une épaisseur de 10 à 200 µm.

5. Procédé suivant l'une des revendications 1 à 4, dans lequel on utilise une colle qui contient une charge minérale ou non organique en une proportion de 20 à 60 % en volume.

6. Procédé suivant l'une des revendications 1 à 5, dans lequel on dépose la colle sur une surface tournée vers le joint de colle et
dans lequel on aboute à peu près à ajustement précis les parties à coller, le cas échéant on les positionne exactement et on les aligne et alors, ou peu après, on les fixe.

7. Utilisation du procédé suivant l'une des revendications précédentes, pour le collage automatique à ajustement précis de composants électriques, électroniques et optiques en des durées de cycle courtes.
